# EUROPEAN PATENT APPLICATION

(11) **EP 3 425 666 A1**
(43) Date of publication of application: **09.01.2019**
(21) Application number: 18180320.6
(22) Date of filing: 28.06.2018
(51) Int. Cl.: H01L 23/495

(54) **SEMICONDUCTOR MODULE**

(30) Priority: 06.07.2017 JP 2017132744
(71) Applicant: TOYOTA JIDOSHA KABUSHIKI KAISHA, Toyota-shi, Aichi 471 8571 (JP)
(72) Inventor: SHIIZAKI, Ryosuke, Toyota-shi, Aichi 471-8571 (JP); AOSHIMA, Masaki, Toyota-shi, Aichi 471-8571 (JP)
(74) Representative: TBK

(57) **Abstract**

A semiconductor module (10) includes a semiconductor substrate (30), a first electrode (32) in contact with a first surface of the semiconductor substrate (30), a second electrode (34) in contact with a second surface of the semiconductor substrate (30), a first conductor (12) connected to the first electrode (32) via a first solder layer (18), and a second conductor (24) connected to the second electrode (34) via a second solder layer (22). The second electrode overlaps the entire first electrode and is wider than the first electrode when seen along a thickness direction of the semiconductor substrate. A recessed portion (40) located along an outer peripheral edge of the first electrode is disposed in a joining surface of the second conductor in contact with the second solder layer to overlap the outer peripheral edge of the first electrode when the semiconductor substrate is seen along the thickness direction.

## Description

### BACKGROUND OF THE INVENTION

### 1. Field of the Invention

The technique that is disclosed in this specification relates to a semiconductor module.

### 2. Description of Related Art

Japanese Unexamined Patent Application Publication No. 2016-046497 (JP 2016-046497 A) discloses a semiconductor module in which conductors are joined by solder to both surfaces of a semiconductor chip. FIG. 18 is a partial enlarged view of the semiconductor module disclosed in JP 2016-046497 A. As illustrated in FIG. 18, a semiconductor chip 160 has a semiconductor substrate 150, a first electrode 110 in contact with one surface 150a of the semiconductor substrate 150, and a second electrode 120 in contact with the other surface 150b of the semiconductor substrate 150. The first electrode 110 is connected to a first conductor 114 by a solder layer 112 and the second electrode 120 is connected to a second conductor 124 by a solder layer 122. Each of the first conductor 114 and the second conductor 124 functions as a heat dissipation member releasing heat from the semiconductor substrate 150.

### SUMMARY OF THE INVENTION

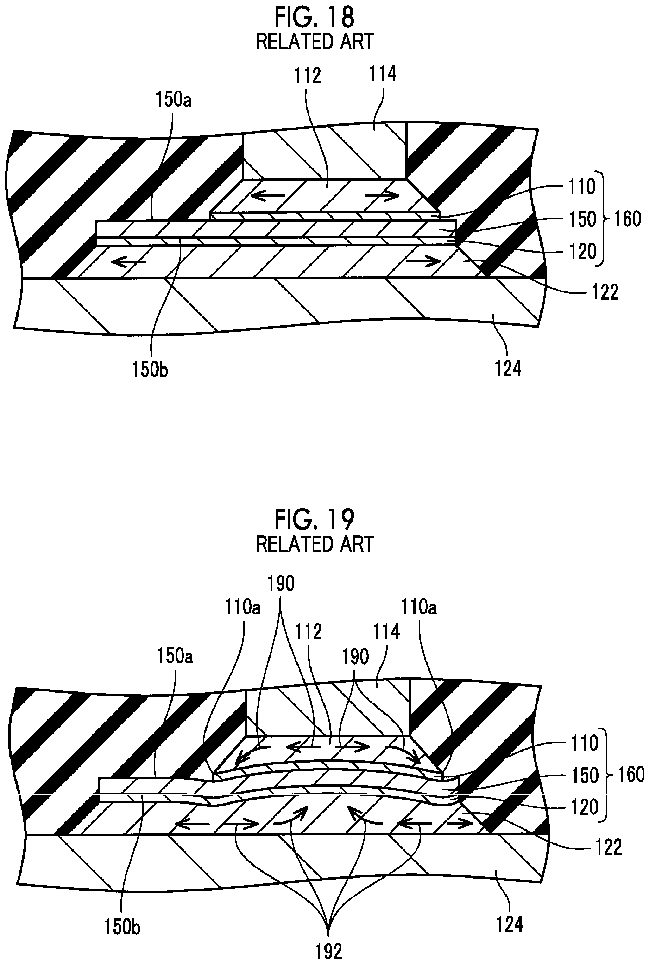

An electrode (such as a signal electrode) other than the first electrode 110 is disposed on the surface 150a of the semiconductor substrate 150, and thus the first electrode 110 is smaller in size than the second electrode 120. Each of the first conductor 114, the second conductor 124, and the semiconductor substrate 150 thermally expands when the semiconductor substrate 150 generates heat. At that time, the expansion amount of the first conductor 114 and the expansion amount of the second conductor 124 exceed the expansion amount of the semiconductor substrate 150 since the linear expansion coefficient of the first conductor 114 and the linear expansion coefficient of the second conductor 124 are larger than the linear expansion coefficient of the semiconductor substrate 150. The solder layer 112 is pulled to the outer peripheral side due to the thermal expansion of the first conductor 114. The solder layer 122 is pulled to the outer peripheral side due to the thermal expansion of the second conductor 124. Stress is repeatedly applied to the solder layers 112, 122 as the semiconductor substrate 150 repeatedly generates heat. Then, solder moves to the outer peripheral side in the solder layer 112 and solder moves to the outer peripheral side in the solder layer 122, as indicated by the arrows in FIG. 18, due to the creep phenomenon of the solder. As the creep phenomenon of the solder continues, the solder moving to the outer peripheral side in the solder layer 112 pressurizes the semiconductor substrate 150 downward near an outer peripheral edge 110a of the first electrode 110 as indicated by the arrows 190 in FIG. 19. As a result, the semiconductor substrate 150 warps downward at the outer peripheral edge 110a of the first electrode 110 as illustrated in FIG. 19. As a result of pressurization by the semiconductor substrate 150 that is warped downward, the solder in the solder layer 122 moves from the pressurized part toward the surroundings. As a result, some of the solder in the solder layer 122 moves toward the lower portion of the middle portion of the first electrode 110 as indicated by the arrows 192 in FIG. 19. Accordingly, the solder layer 122 pressurizes the semiconductor substrate 150 upward at the position of the middle portion of the first electrode 110 and the semiconductor substrate 150 warps upward. Degradation of the semiconductor substrate 150 results from the warpage of the semiconductor substrate 150 illustrated in FIG. 19. Then, the reliability of the semiconductor module is reduced. Although the semiconductor chip 160 is covered with insulating resin in FIGS. 18 and 19, it has been confirmed that warpage as in FIG. 19 occurs even in a case where the semiconductor chip is not covered with insulating resin. Therefore, this specification proposes a technique for suppressing semiconductor substrate warpage attributable to a creep phenomenon of solder in a semiconductor module.

An aspect of the disclosure relates to a semiconductor module including a semiconductor substrate, a first electrode in contact with a first surface of the semiconductor substrate in a range except an outer peripheral region of the first surface of the semiconductor substrate, a second electrode in contact with a second surface of the semiconductor substrate, the first surface and the second surface being opposite surfaces of the semiconductor substrate, a first conductor connected to the first electrode via a first solder layer, and a second conductor connected to the second electrode via a second solder layer. The second electrode overlaps the entire first electrode and is wider than the first electrode when seen along a thickness direction of the semiconductor substrate. A recessed portion located along an outer peripheral edge of the first electrode is disposed in a joining surface of the second conductor in contact with the second solder layer to overlap the outer peripheral edge of the first electrode when the semiconductor substrate is seen along the thickness direction.

In the semiconductor module, the recessed portion located along the outer peripheral edge of the first electrode is disposed in the joining surface of the second conductor in contact with the second solder layer to overlap the outer peripheral edge of the first electrode when the semiconductor substrate is seen along the thickness direction. Since the second solder layer in the recessed portion (that is, the second solder layer below the outer peripheral edge of the first electrode) is thick, the second solder layer in the recessed portion has relatively high elasticity. Accordingly, even when the semiconductor substrate is pressurized downward below the outer peripheral edge of the first electrode due to the creep phenomenon of the first solder layer, a creep phenomenon is unlikely to occur in the second solder layer in the recessed portion. Accordingly, pressure on the semiconductor substrate attributable to the creep phenomenon of the second solder layer is unlikely to be generated and warpage of the semiconductor substrate can be suppressed. Therefore, in the semiconductor module according to the aspect of the disclosure, time degradation of the semiconductor substrate is unlikely to occur.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a sectional view of a semiconductor module;
FIG. 2 is an enlarged sectional view of a semiconductor chip and the surroundings thereof;
FIG. 3 is a plan view showing the semiconductor chip from above;
FIG. 4 is a perspective view of a recessed portion and a projecting portion;
FIG. 5 is an explanatory drawing of a step in which the recessed portion and the projecting portion are formed;
FIG. 6 is an explanatory drawing of a step in which the recessed portion and the projecting portion are formed;
FIG. 7 is an enlarged sectional view of a semiconductor module according to a modification example that corresponds to FIG. 2;
FIG. 8 is an enlarged sectional view of a semiconductor module according to a modification example that corresponds to FIG. 2;
FIG. 9 is an enlarged sectional view of a semiconductor module according to a modification example that corresponds to FIG. 2;
FIG. 10 is an enlarged sectional view of a semiconductor module according to a modification example that corresponds to FIG. 2;
FIG. 11 is a sectional view of a semiconductor module according to a modification example that corresponds to FIG. 1;
FIG. 12 is a sectional view of a semiconductor module according to a modification example that corresponds to FIG. 1;
FIG. 13 is a sectional view of a semiconductor module according to a modification example that corresponds to FIG. 1;
FIG. 14 is a sectional view of a semiconductor module according to a modification example that corresponds to FIG. 1;
FIG. 15 is a plan view of a semiconductor module according to a modification example that corresponds to FIG. 3;
FIG. 16 is a sectional view of a semiconductor module according to a modification example that corresponds to FIG. 3;
FIG. 17 is a sectional view of a semiconductor module according to a modification example that corresponds to FIG. 3;
FIG. 18 is an enlarged sectional view of a semiconductor chip of a semiconductor module according to the related art and the surroundings thereof; and
FIG. 19 is an enlarged sectional view of the semiconductor chip of the semiconductor module according to the related art and the surroundings thereof.

### DETAILED DESCRIPTION OF EMBODIMENTS

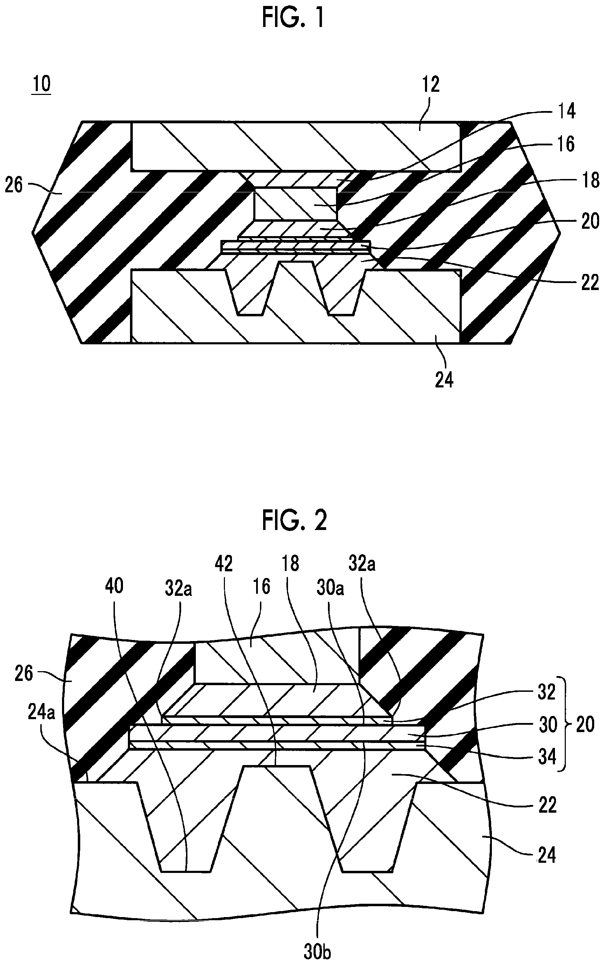

As illustrated in FIG. 1, a semiconductor module 10 according to an embodiment has an upper lead frame 12, a metal block 16, a semiconductor chip 20, a lower lead frame 24, and an insulating resin 26.

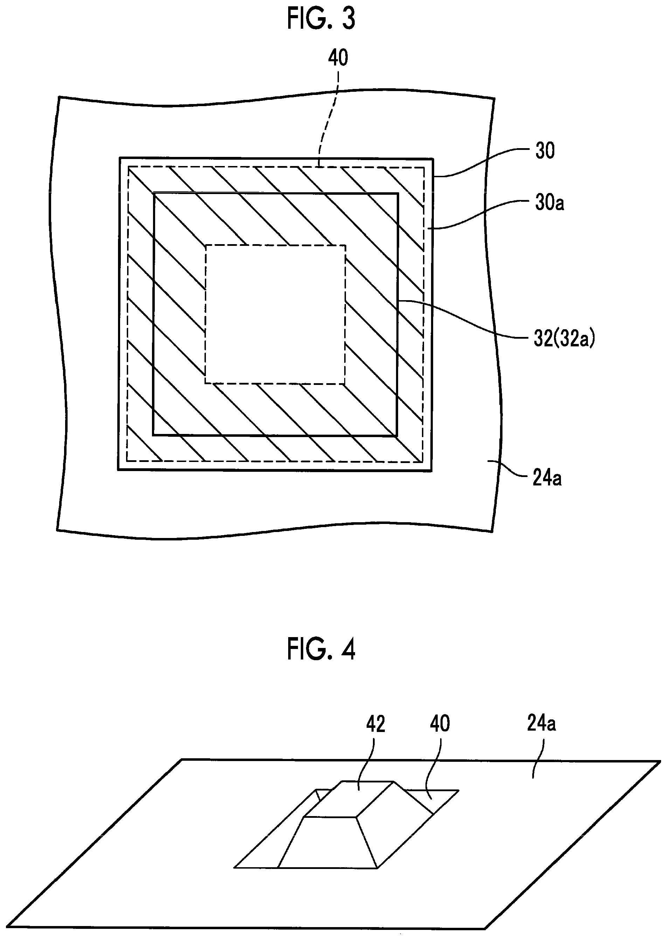

As illustrated in FIG. 2, the semiconductor chip 20 has a SiC substrate 30, an upper electrode 32, and a lower electrode 34. The upper electrode 32 is in contact with an upper surface 30a of the SiC substrate 30. FIG. 3 is a plan view showing the semiconductor chip 20 from above. As illustrated in FIG. 3, the upper electrode 32 covers the middle portion of the upper surface 30a of the SiC substrate 30 and does not cover the outer peripheral portion of the upper surface 30a. A signal electrode (not illustrated) is disposed at a part of the outer peripheral portion of the upper surface 30a. The signal electrode is connected to a signal terminal (not illustrated) by a wire. As illustrated in FIG. 2, the lower electrode 34 covers the whole area of a lower surface 30b of the SiC substrate 30. Accordingly, when seen along the thickness direction of the SiC substrate 30 as in FIG. 3, the lower electrode 34 (that is, the range that has the same size as the SiC substrate 30 in FIG. 3) overlaps the entire upper electrode 32 and is wider than the upper electrode 32. A semiconductor device such as a metal oxide semiconductor field effect transistor (MOSFET) for high current control and a diode is formed in the SiC substrate 30.

The metal block 16 is formed of a metal (more specifically, copper). As illustrated in FIGS. 1 and 2, the metal block 16 is disposed above the semiconductor chip 20. The lower surface of the metal block 16 is connected to the upper electrode 32 of the semiconductor chip 20 by a first solder layer 18.

The upper lead frame 12 is formed of a metal (more specifically, copper). As illustrated in FIG. 1, the upper lead frame 12 is disposed above the metal block 16. The lower surface of the upper lead frame 12 is connected to the upper surface of the metal block 16 by a solder layer 14.

The lower lead frame 24 is formed of a metal (more specifically, copper). As illustrated in FIGS. 1 and 2, the lower lead frame 24 is disposed below the semiconductor chip 20. An upper surface 24a of the lower lead frame 24 is connected to the lower electrode 34 of the semiconductor chip 20 by a second solder layer 22. The upper surface 24a of the lower lead frame 24 has a recessed portion 40 and a projecting portion 42. As illustrated in FIGS. 3 and 4, the recessed portion 40 surrounds the projection portion in the upper surface 24a. In FIG. 3, the range in which the recessed portion 40 is disposed is indicated by a diagonal line. When seen along the thickness direction of the SiC substrate 30 as in FIG. 3, the whole of an outer peripheral edge 32a of the upper electrode 32 overlaps the recessed portion 40. The projecting portion 42 is disposed in a range surrounded by the recessed portion 40. As illustrated in FIGS. 2 and 4, the projecting portion 42 protrudes upward beyond the upper surface 24a on the outer peripheral side of the recessed portion 40. The whole of the recessed portion 40 and the projecting portion 42 is covered with the second solder layer 22. The second solder layer 22 is joined to the surface of the projecting portion 42, the inner surface of the recessed portion 40, and the upper surface 24a on the outer peripheral side of the recessed portion 40 (upper surface 24a near the recessed portion 40).

As illustrated in FIG. 1, a laminate of the upper lead frame 12, the metal block 16, the semiconductor chip 20, and the lower lead frame 24 is covered by the insulating resin 26. The entire surface of the laminate except the upper surface of the upper lead frame 12 and the lower surface of the lower lead frame 24 is covered by the insulating resin 26. The upper surface of the upper lead frame 12 and the lower surface of the lower lead frame 24 are connected to a cooler (not illustrated).

The upper lead frame 12 and the lower lead frame 24 function as wiring of the semiconductor module 10. A current is allowed to flow to the semiconductor chip 20 via the upper lead frame 12 and the lower lead frame 24. The upper lead frame 12 and the lower lead frame 24 also function as a heat sink. Once a current flows to the semiconductor chip 20, the semiconductor chip 20 generates heat. The heat generated by the semiconductor chip 20 is dissipated via the lower lead frame 24 and dissipated via the metal block 16 and the upper lead frame 12. Accordingly, once a current flows to the semiconductor chip 20, the temperatures of the lower lead frame 24, the metal block 16, and the upper lead frame 12 become relatively high. The linear expansion coefficient of the lower lead frame 24 and the linear expansion coefficient of the metal block 16 are higher than the linear expansion coefficient of the SiC substrate 30. Accordingly, the expansion amounts of the lower lead frame 24 and the metal block 16 exceed the expansion amount of the SiC substrate 30. Since the expansion amount of the SiC substrate 30 is small and the expansion amount of the lower lead frame 24 is large, high thermal stress is applied to the second solder layer 22 between the SiC substrate 30 and the lower lead frame 24. Accordingly, once the semiconductor chip 20 is repeatedly energized, thermal stress is repeatedly applied to the second solder layer 22 and the solder in the second solder layer 22 moves toward the outer peripheral side due to the creep phenomenon of the solder. Since the expansion amount of the SiC substrate 30 is small and the expansion amount of the metal block 16 is large, high thermal stress is applied to the first solder layer 18 between the SiC substrate 30 and the metal block 16. Accordingly, once the semiconductor chip 20 is repeatedly energized, thermal stress is repeatedly applied to the first solder layer 18 and the solder in the first solder layer 18 moves toward the outer peripheral side due to the creep phenomenon of the solder. Once the solder in the first solder layer 18 moves toward the outer peripheral side, pressure increases at the outer peripheral edge of the first solder layer 18 (that is, near the outer peripheral edge 32a of the upper electrode 32). Accordingly, the first solder layer 18 pressurizes the SiC substrate 30 downward near the outer peripheral edge 32a of the upper electrode 32. The pressure is applied to the second solder layer 22 below the outer peripheral edge 32a of the upper electrode 32. Since the recessed portion 40 is disposed below the outer peripheral edge 32a of the upper electrode 32, the pressure is applied to the second solder layer 22 in the recessed portion 40. Since the second solder layer 22 in the recessed portion 40 is thick, the second solder layer 22 in the recessed portion 40 has relatively high elasticity and is unlikely to be plastically deformed. Accordingly, even when pressure is repeatedly applied to the second solder layer 22 in the recessed portion 40, a solder movement attributable to the pressure is unlikely to occur. Since the lower lead frame 24 has the projecting portion 42, a movement of the solder in the second solder layer 22 toward the middle portion is hindered by the side surfaces of the projecting portion 42. Accordingly, in the second solder layer 22, a solder movement toward the middle portion as indicated by the arrows 192 in FIG. 19 rarely occurs. Accordingly, in the semiconductor module 10 according to the embodiment, pressure with which the second solder layer 22 pushes the middle portion of the SiC substrate 30 upward is unlikely to be generated. Accordingly, in the semiconductor module 10 according to the embodiment, semiconductor substrate warpage as in FIG. 19 is suppressed. Therefore, in the semiconductor module 10, time degradation of the SiC substrate 30 can be suppressed and high reliability can be maintained.

A simulation result will be described below with regard to the warpage of the SiC substrate 30 at a time when a predetermined number of thermal cycles were applied. A semiconductor module (Sample 1) in which the lower lead frame 24 does not have the recessed portion 40 and the projecting portion 42 (that is, a semiconductor module in which the upper surface 24a of the lower lead frame 24 is flat as in the related art) has resulted in a warpage of approximately 6.82 × 10⁻⁴ mm in the SiC substrate 30. SiC substrates are especially prone to warpage as described above because general SiC substrates are extremely thin with a thickness of 150 µm or less. A semiconductor module (Sample 2) in which the lower lead frame 24 has the recessed portion 40 and does not have the projecting portion 42 has resulted in a warpage of approximately 3.78 × 10⁻⁴ mm in the SiC substrate 30 under the same conditions as Sample 1. Comparison between Samples 1 and 2 clearly shows that warpage of the SiC substrate 30 can be effectively suppressed by the recessed portion 40 being provided. A semiconductor module (Sample 3) in which the lower lead frame 24 has the recessed portion 40 and the projecting portion 42 (that is, the configuration of FIGS. 1 and 2) has resulted in a warpage of approximately 1.74 × 10⁻⁴ mm in the SiC substrate 30 under the same conditions as Sample 2. Comparison between Samples 2 and 3 clearly shows that warpage of the SiC substrate 30 can be more effectively suppressed by the projecting portion 42 being provided.

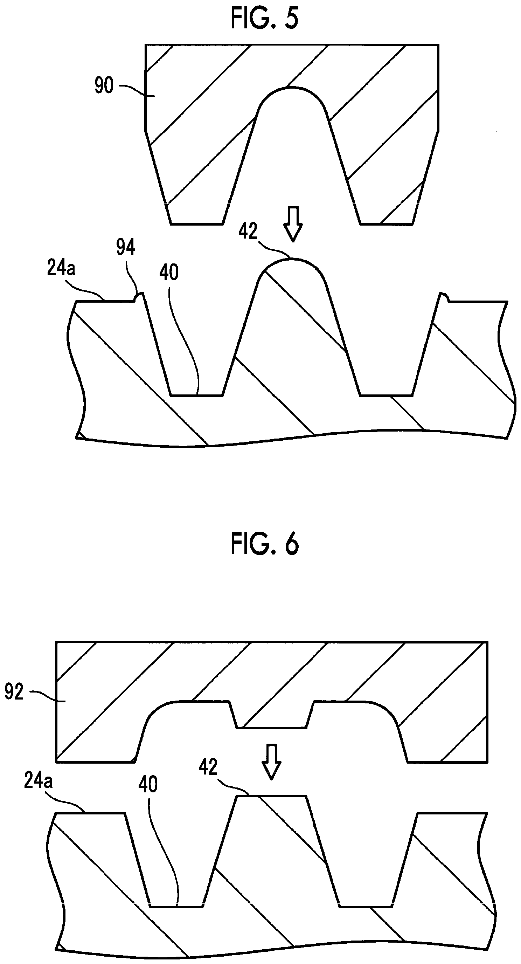

Steps in which the recessed portion 40 and the projecting portion 42 are formed are illustrated in FIGS. 5 and 6. Firstly, the flat upper surface 24a of the lower lead frame 24 that is yet to be processed is pressed by a mold 90 illustrated in FIG. 5. As a result, the recessed portion 40 and the projecting portion 42 are formed. In the stage of FIG. 5, the upper surface of the projecting portion 42 is curved and protuberant. In the stage of FIG. 5, the outer peripheral edge of the recessed portion 40 has a burr 94. The upper surface of the projecting portion 42 and the burr 94 are pressed by a mold 92 illustrated in FIG. 6. As a result, the upper surface of the projecting portion 42 is flattened and the burr 94 disappears.

A modification example will be described below. The semiconductor module according to the modification example to be described below has the same configuration as the semiconductor module 10 according to the above-described embodiment except particularly mentioned parts.

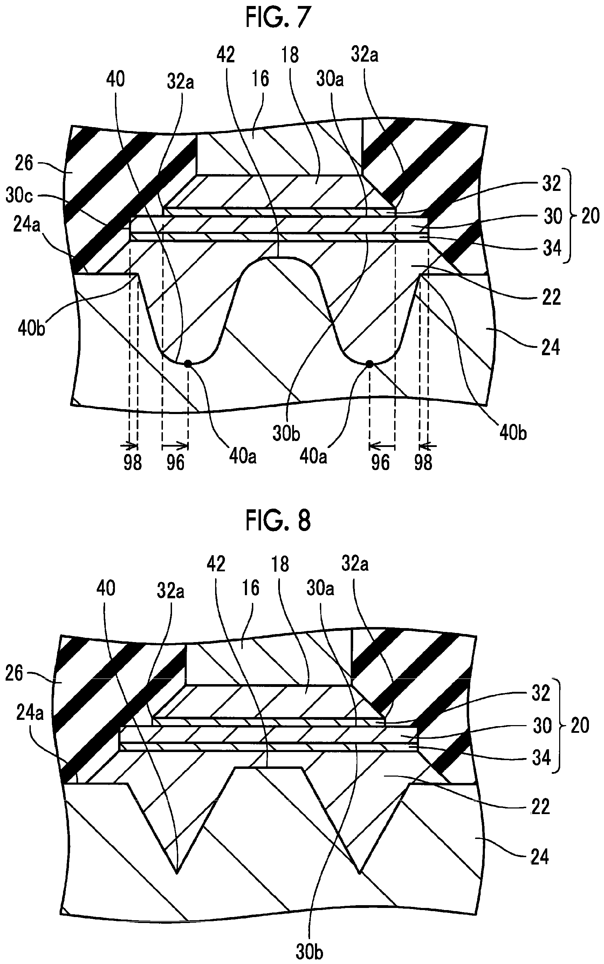

The sectional shape of the recessed portion 40 can be appropriately changed. FIG. 7 shows the sectional shape of the recessed portion 40 according to the modification example. In FIG. 7, the recessed portion 40 has a U-shaped cross section. As indicated by the arrows 96, in FIG. 7, a deepest portion 40a of the recessed portion 40 is positioned on the inner peripheral side of the outer peripheral edge 32a of the upper electrode 32 (more specifically, the deepest portion 40a is positioned on the inner peripheral side of the outer peripheral edge 32a of the upper electrode 32 when the SiC substrate 30 is seen along the thickness direction). A simulation similar to Sample 1 described above was performed with the configuration of the semiconductor module illustrated in FIG. 7 (Sample 4), and the simulation has resulted in a warpage of approximately 2.35 × 10⁻⁴ mm in the SiC substrate 30. A simulation similar to Sample 4 described above was performed with a configuration in which the deepest portion 40a is positioned on the outer peripheral side of the outer peripheral edge 32a of the upper electrode 32 (Sample 5), and the simulation has resulted in a warpage of approximately 2.49 × 10⁻⁴ mm in the SiC substrate. Comparison between Samples 4 and 5 clearly shows that warpage of the SiC substrate 30 can be further suppressed by the deepest portion 40a of the recessed portion 40 being disposed on the inner peripheral side of the outer peripheral edge 32a of the upper electrode 32.

As indicated by the arrows 98, in FIG. 7, an outer peripheral edge 40b of the recessed portion 40 is positioned on the inner peripheral side of an outer peripheral edge 30c of the SiC substrate 30 (more specifically, the outer peripheral edge 40b is positioned on the inner peripheral side of the outer peripheral edge 30c when the SiC substrate 30 is seen along the thickness direction). The warpage of the SiC substrate 30 in the configuration of FIG. 7 (that is, Sample 4) is 2.35 × 10⁻⁴ mm as described above. A simulation similar to Sample 4 described above was performed with a configuration in which the outer peripheral edge 40b of the recessed portion 40 is positioned on the outer peripheral side of the outer peripheral edge 30c of the SiC substrate 30 (Sample 6), and the simulation has resulted in a warpage of approximately 4.56 × 10⁻⁴ mm in the SiC substrate 30. Comparison between Samples 4 and 6 clearly shows that warpage of the SiC substrate 30 can be further suppressed by the outer peripheral edge 40b of the recessed portion 40 being disposed on the inner peripheral side of the outer peripheral edge 30c of the SiC substrate 30.

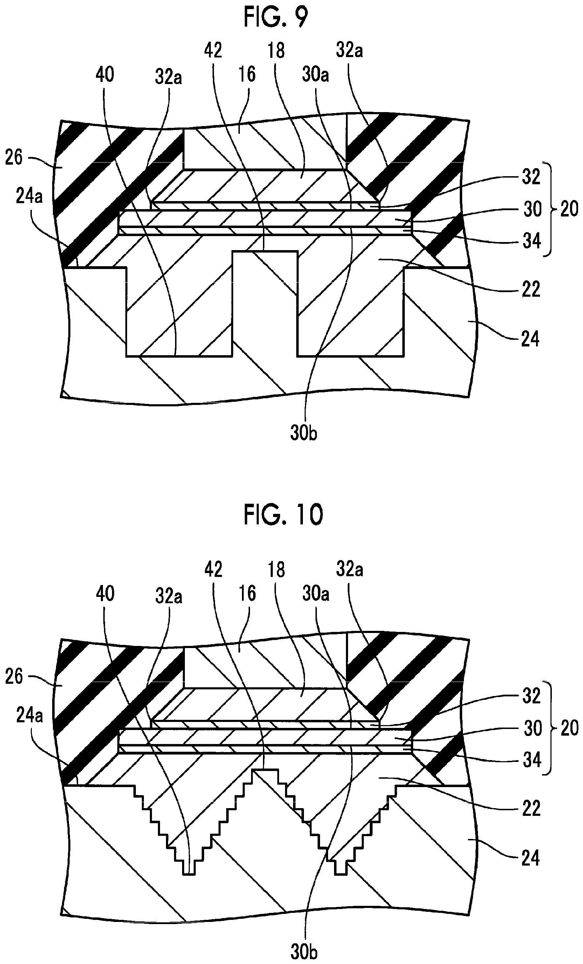

The recessed portion 40 may have a V-like sectional shape as in FIG. 8. The recessed portion 40 may have a rectangular sectional shape as in FIG. 9. The recessed portion 40 may have a stepwise sectional shape as in FIG. 10.

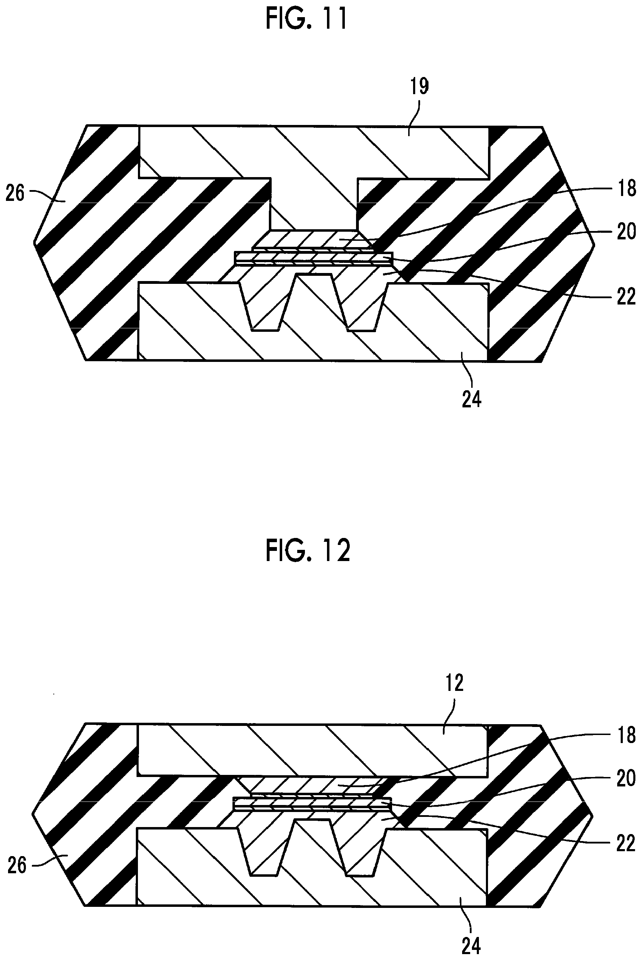

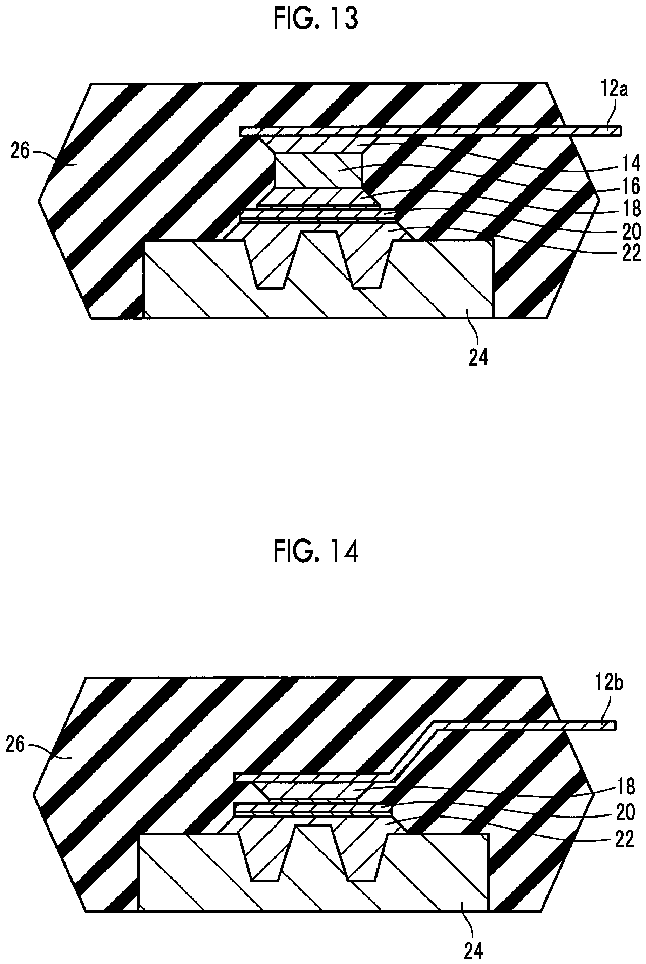

In FIG. 1, the metal block 16 and the upper lead frame 12 are connected by the solder layer 14. Alternatively, the semiconductor module may be configured by means of a metal part 19 shaped such that the metal block 16 and the upper lead frame 12 are integrated as illustrated in FIG. 11. As illustrated in FIG. 12, the upper lead frame 12 may be connected to the upper electrode of the semiconductor chip 20 via the first solder layer 18 and without the metal block 16. As illustrated in FIG. 13, a terminal 12a thinner than the upper lead frame 12 may be connected to the upper surface of the metal block 16. As illustrated in FIG. 14, a thin terminal 12b may be connected to the upper electrode of the semiconductor chip 20 not via the metal block 16.

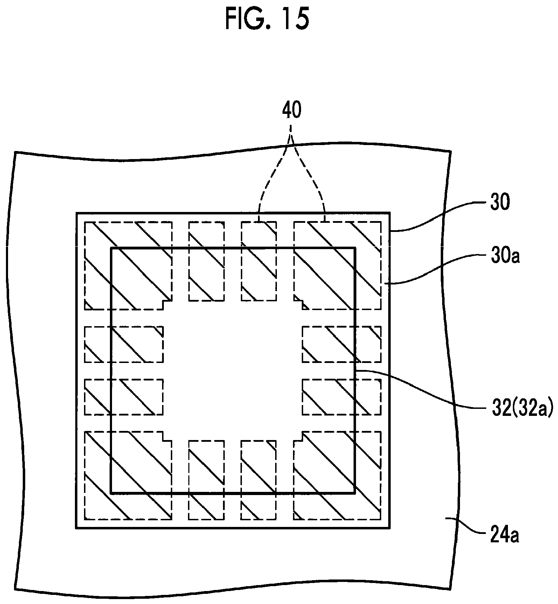

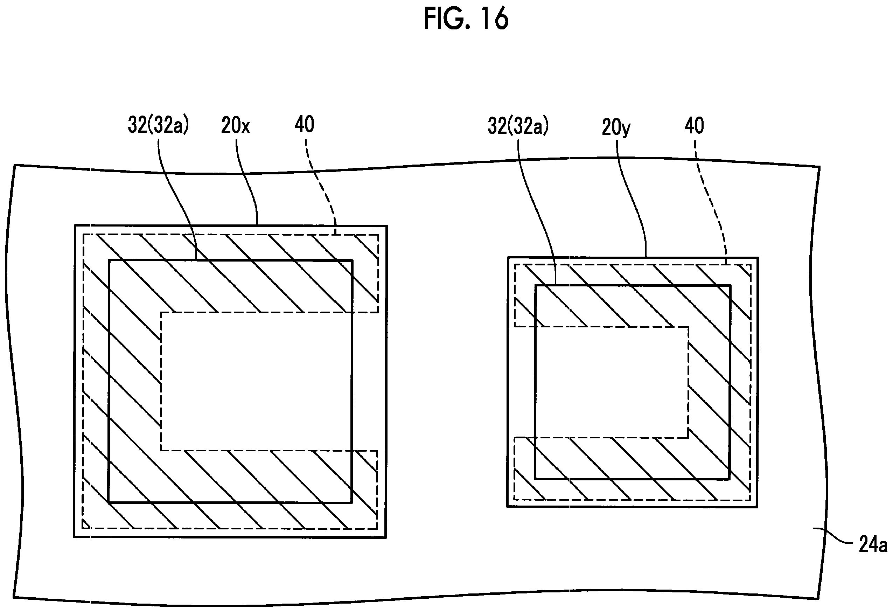

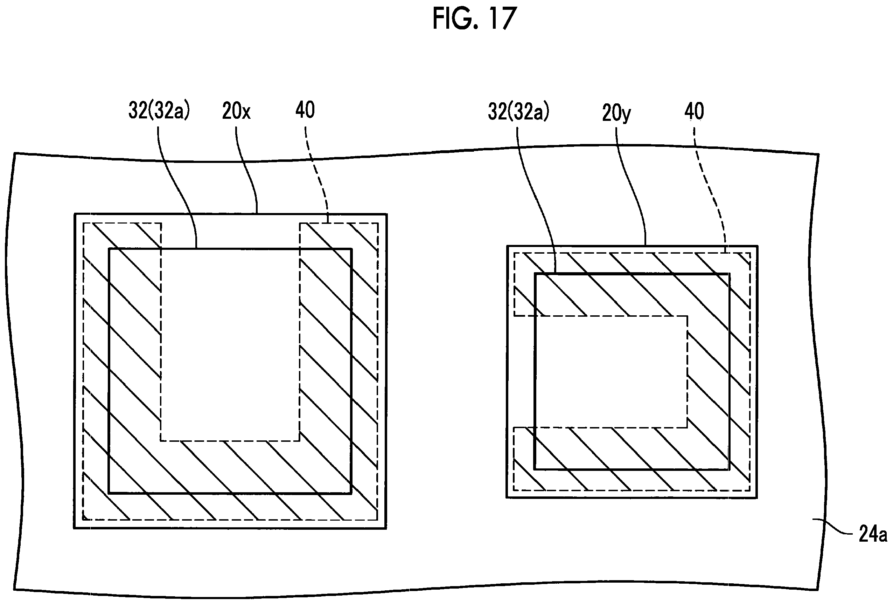

As illustrated in FIG. 4, in the semiconductor module 10 according to the embodiment described above, the recessed portion 40 has a frame shape surrounding a range in the upper surface 24a of the lower lead frame 24. Alternatively, the recessed portion 40 may not have a frame shape insofar as the recessed portion 40 is disposed along the lower portion of the outer peripheral edge 32a of the upper electrode 32. For example, as illustrated in FIG. 15, the recessed portions 40 may be intermittently distributed along the lower portion of the outer peripheral edge 32a of the upper electrode 32. As illustrated in FIG. 16, a partially interrupted recessed portion 40 may extend along the lower portion of the outer peripheral edge 32a of the upper electrode 32. In the configuration that is illustrated in FIG. 16, two semiconductor chips 20x, 20y are mounted on the lower lead frame 24. For example, the semiconductor chip 20x may constitute a MOSFET and the semiconductor chip 20y may constitute a diode. In this case, the recessed portion 40 may not be provided on the sides of the upper electrode 32 of the semiconductor chip 20x and the upper electrode 32 of the semiconductor chip 20y that face each other. As illustrated in FIG. 17, the recessed portion 40 may be interrupted.

Although the entire recessed portion 40 is covered with the second solder layer 22 in the embodiment described above, a part of the recessed portion 40 may not be covered with the second solder layer 22.

Although the semiconductor chip 20 is covered with the insulating resin 26 in the embodiment described above, the semiconductor chip 20 may not be covered with the insulating resin 26. The semiconductor chip 20 may be covered with silicon gel or the like instead of the insulating resin 26.

Relationships between the components of the semiconductor module according to the embodiment described above and the components of the semiconductor module according to the disclosure will be described below. The upper electrode according to the embodiment is an example of a first electrode according to the disclosure. The lower electrode according to the embodiment is an example of a second electrode according to the disclosure. The upper lead frame according to the embodiment is an example of a first conductor according to the disclosure. The lower lead frame according to the embodiment is an example of a second conductor according to the disclosure. The projecting portion according to the embodiment is an example of a joining surface in a range surrounded by a recessed portion according to the disclosure.

Technical elements disclosed in this specification will be listed below. Each of the following technical elements is independently useful.

In the semiconductor module according to an example disclosed in this specification, the recessed portion may have a frame shape in the joining surface. The entire outer peripheral edge of the first electrode may overlap the recessed portion when the semiconductor substrate is seen along the thickness direction.

According to the above configuration, warpage of the semiconductor substrate can be more desirably suppressed.

In the semiconductor module according to the example disclosed in this specification, the joining surface in a range surrounded by the recessed portion may protrude to the semiconductor substrate side beyond a surface of the second conductor on an outer peripheral side of the recessed portion.

According to the above configuration, warpage of the semiconductor substrate can be more desirably suppressed.

In the semiconductor module according to the example disclosed in this specification, a deepest portion of the recessed portion may be positioned on an inner peripheral side of the outer peripheral edge of the first electrode when the semiconductor substrate is seen along the thickness direction.

According to the above configuration, warpage of the semiconductor substrate can be more desirably suppressed.

In the semiconductor module according to the example disclosed in this specification, the second solder layer may cover the recessed portion and the surface of the second conductor on the outer peripheral side of the recessed portion.

The embodiment described in detail above is merely an example and does not limit the scope of claims. The technique disclosed in the scope of claims includes various modifications and changes based on the specific example described above. The technical elements described in this specification or the drawings demonstrate technical utility independently or through various combinations and are not limited to the combinations disclosed in the filed claims. The technique exemplified in this specification or the drawings achieves multiple purposes at the same time and retains technical utility even when merely one of the purposes is achieved.

A semiconductor module (10) includes a semiconductor substrate (30), a first electrode (32) in contact with a first surface of the semiconductor substrate (30), a second electrode (34) in contact with a second surface of the semiconductor substrate (30), a first conductor (12) connected to the first electrode (32) via a first solder layer (18), and a second conductor (24) connected to the second electrode (34) via a second solder layer (22). The second electrode overlaps the entire first electrode and is wider than the first electrode when seen along a thickness direction of the semiconductor substrate. A recessed portion (40) located along an outer peripheral edge of the first electrode is disposed in a joining surface of the second conductor in contact with the second solder layer to overlap the outer peripheral edge of the first electrode when the semiconductor substrate is seen along the thickness direction.

## Claims

1. A semiconductor module (10) comprising:
a semiconductor substrate (30);
a first electrode (32) in contact with a first surface of the semiconductor substrate (30) in a range except an outer peripheral region of the first surface of the semiconductor substrate (30);
a second electrode (34) in contact with a second surface of the semiconductor substrate (30), the first surface and the second surface being opposite surfaces of the semiconductor substrate (30);
a first conductor (12) connected to the first electrode (32) via a first solder layer (18); and
a second conductor (24) connected to the second electrode (34) via a second solder layer (22), wherein:
the second electrode (34) overlaps the entire first electrode (32) and is wider than the first electrode (32) when seen along a thickness direction of the semiconductor substrate (30); and
a recessed portion (40) located along an outer peripheral edge of the first electrode (32) is disposed in a joining surface of the second conductor (24) in contact with the second solder layer (22) to overlap the outer peripheral edge of the first electrode (32) when the semiconductor substrate (30) is seen along the thickness direction.

2. The semiconductor module (10) according to claim 1, wherein:
the recessed portion (40) surrounds a range in the joining surface; and
the entire outer peripheral edge of the first electrode (32) overlaps the recessed portion (40) when the semiconductor substrate (30) is seen along the thickness direction.

3. The semiconductor module (10) according to claim 2, wherein the joining surface (42) in the range surrounded by the recessed portion (40) protrudes to the semiconductor substrate (30) beyond a surface of the second conductor (24) on an outer peripheral side of the recessed portion (40).

4. The semiconductor module (10) according to claim 3, wherein a deepest portion of the recessed portion (40) is positioned on an inner peripheral side of the outer peripheral edge of the first electrode (32) when the semiconductor substrate (30) is seen along the thickness direction.

5. The semiconductor module (10) according to any one of claims 2 to 4, wherein the second solder layer (22) covers the recessed portion (40) and the surface of the second conductor (24) on the outer peripheral side of the recessed portion (40).

6. The semiconductor module (10) according to any one of claims 1 to 5, wherein an outer peripheral edge of the recessed portion (40) is positioned on an inner peripheral side of an outer peripheral edge of the semiconductor substrate (30) when the semiconductor substrate (30) is seen along the thickness direction.

7. The semiconductor module (10) according to any one of claims 1 to 6, wherein the semiconductor substrate (30) is a SiC substrate.

8. The semiconductor module (10) according to claim 1, wherein a plurality of the recessed portions (40) located along the outer peripheral edge of the first electrode (32) is disposed in the joining surface of the second conductor (24) in contact with the second solder layer (22) to overlap the outer peripheral edge of the first electrode (32) when the semiconductor substrate (30) is seen along the thickness direction.
